# EUROPEAN PATENT SPECIFICATION

(11) **EP 0 289 045 B1**
(45) Date of publication and mention of the grant of the patent: **06.07.1994**
(21) Application number: 88106915.7
(22) Date of filing: 29.04.1988
(51) Int. Cl.: H01L 21/00

(54) **Apparatus for fabricating semiconductor devices**
Vorrichtung zur Herstellung von Halbleiter-Bauelementen
Appareil pour la fabrication de dispositifs semi-conducteurs

(30) Priority: 01.05.1987 JP 108117/87; 01.05.1987 JP 108118/87; 01.05.1987 JP 108119/87
(43) Date of publication of application: 02.11.1988
(73) Proprietor: SUMITOMO ELECTRIC INDUSTRIES LIMITED, Osaka-shi, Osaka 541 (JP)
(72) Inventor: Nishiguchi, Masanori Yokohama Works, Yokohama-shi Kanagawa- (JP); Sekiguchi, Takeshi Yokohama Works, Yokohama-shi Kanagawa- (JP); Tato, Nobuyoshi Yokohama Works, Yokohama-shi Kanagawa- (JP)
(74) Representative: Ritter und Edler von Fischern, Bernhard,Dipl.-Ing.

(56) References cited:
- EP-A- 0 080 765
- DE-A- 1 908 597
- FR-A- 1 481 711
- US-A- 4 410 168

## Description

The present invention generally relates to an apparatus for fabricating a semiconductor device and, more particularly, to an apparatus for individually separating semiconductor chips formed on a semiconductor wafer.

### (Description of the Prior Art)

A technique for individually separating a plurality of chips formed on a single wafer is called "dicing". As a separating method, there are two systems; a scribing system in which the wafer is scribed along the chips to form scribed grooves with the use of a laser or a diamond needle and the chips are subsequently mechanically separated, and a dicing saw system in which the high speed rotation of a thin diamond blade is used to cut deep so that the chips can be mechanically separated or to render the chips to be separable during the cutting.

The wafer half-cut by use of either the scribing technique or the dicing technique is divided into the individual chips by a mechanical means. Fig. 5 illustrates a schematic construction of one prior art apparatus for dividing the wafer.

The apparatus shown in Fig. 5 comprises a base 1 having a rubber mat 2 placed thereabove. A half-cut wafer 3 having first and second surfaces opposite to each other and having chips formed on the first surface thereof is placed on the rubber mat 2 with the first and second surfaces thereof confronting the rubber mat 2 and upwardly, respectively. Prior to the placement of the wafer 3 on the rubber mat, an adhesive tape 15 is applied to the second surface of the wafer so that, when the wafer 3 is divided or separated, the chips will not scatter and can be retained in position.

While a peripheral surface of a generally cylindrical rod-like roller 4 is pressed against the second surface of the wafer 3, the roller 4 is driven to rotate about the longitudinal axis thereof to separate the wafer 3. The chips divided from the wafer are separated on the tape 15 and are suitably cut according to the need for actual use.

As hereinabove discussed, the prior art apparatus for dividing the chips formed on the generally circular wafer is so designed that the wafer supported by the rubber mat rich of elasticity placed on the base is divided while the cylindrical rod-like roller is pressed thereagainst. Both of the wafer and the rubber mat when pressed by the cylindrical rod-like roller are downwardly loaded to deform. Because of this, the wafer can be cut only in one direction and, in order for the wafer which has been scribed to be cut in both X-axis and Y-axis directions, a process is required to be repeated two times.

Moreover, while a pressing surface exhibited by the rotation of the cylindrical rod-like roller is flat, a peripheral area of the wafer may have a film such as SiN film left unremoved, rendering the peripheral area of the wafer to be thicker than the remainder thereof. Therefore, it occurs that a greater pressing force acts on the peripheral area of the wafer than on a central area thereof.

Furthermore, according to the prior art apparatus, localized areas of the wafer tend to be excessively pressed to such an extent as to result in breakage of the wafer and/or damages to the wirings fabricated on the wafer. In order to avoid these problems, the adjustment of the pressing force is required, rendering the apparatus as a whole to be high in manufacturing cost. In addition, subsequent to the separation of the chips, the adhesive tape must be expanded to separate the chips individually, requiring the increased manufacturing steps.

DE-A-1908597 discloses an apparatus for separating a wafer into chips, in which the wafer is placed on a flexible mat over a cavity. By means of an applied difference of air pressure across the mat, the wafer is pressed into the cavity to break the wafer along scribed lines into a multiplicity of chips.

### SUMMARY OF THE INVENTION

The present invention has been devised with a view to substantially eliminating the above described problems inherent in the prior art apparatus and has for its essential object to provide an improved apparatus for fabricating a semiconductor device which is effective to accurately separate the chips through a single process without the excessive pressing force applied.

In order to accomplish the above described object of the present invention, an apparatus for making a semiconductor device is provided as disclosed in claim 1. According to the present invention the apparatus comprises a flexible mat, means for supporting the flexible mat in a substantially horizontal position, a pressing means having a generally hemispherical convex body and supported for movement up and down, and a drive means for driving one of the pressing means and supporting means relative to the other of the pressing means and supporting means so as to move up and down. The wafer having the first and second surfaces opposite to each other with the chips formed on the first surface thereof is placed on the mat with the chips confronting the flexible mat. The convex body of the pressing means is pressed against the second surface of the wafer to separate the chips on the wafer individually.

Preferably, the flexible mat may be circular in shape and may be made of rubber.

Preferably, the drive means may be adapted to drive the pressing means relative to the wafer.

Preferably, the pressing means may be constituted by at least three rods mounted upright on the support means and a pressing plate having the convex body and supported by the three upright rods. The convex body may have a surface area substantially larger than the wafer.

During use of the apparatus of the present invention, the wafer placed on the flexible mat with the first surface thereof confronting the flexible mat is pressed under a predetermined pressure by the pressing means with the convex body contacting the second surface of the wafer. The wafer so pressed deforms to a shape conforming to, and so as to follow, the shape of the convex body of the pressing means whereby cracking of the wafer is initiated from a center thereof, and no higher pressure than the predetermined pressure acts on that portion of the wafer where the cracking has taken place.

Accordingly, even where the wafer has the peripheral area having a thickness greater than that of the remainder thereof because of the presence of the film such as SiN film, the cracking of the wafer takes place from the central area thereof with no substantial possibility of the higher pressure acting on the peripheral area of the wafer than that on the central area thereof. Therefore, the chips on the wafer which has been half-cut can be progressively separated from the central area of the wafer in a direction radially outwardly thereof while the predetermined pressure acts uniformly thereon.

In view of the foregoing, the wafer can be accurately divided into the plurality of chips without damaging the chips and in one process. If the flexible mat is circular in shape, and since the wafer pressed by the pressing means is also circular in shape, both of the mat and the wafer can deform simultaneously with each other so as to follow the curvature of the convex body of the pressing means when the pressing means is applied thereto, and therefore, the pressing force so applied to the wafer is uniform over the whole chips enough to avoid any possible damage to the chips which would occur when the chips are separated.

In a preferred embodiment of the present invention, the apparatus may further comprise means for supporting a tape, upon which the wafer is to be placed, beneath the mat under tension, and a heating means for heating the convex body of the pressing means.

According to this preferred embodiment of the present invention, the pressing means may comprise a wafer ring surrounding the convex body and supported for movement up and down, and a ring drive means for driving the wafer ring up and down. Furthermore, the convex body of the pressing means is preferably heated to about 60°C.

With the apparatus according to this preferred embodiment of the present invention, while it operates in a manner substantially similar to that according to the first preferred embodiment, the convex body heated to a predetermined temperature is pressed against the second surface of the wafer through the tape to separate the chips and, at the same time, the tape is caused to expand to allow the complete separation of the chips. The heating of the convex body is advantageous in that the tape is allowed to expand readily to facilitate a ready separation of the chips from the wafer, or a ready breakage of the wafer into the chips.

The use of the tape support means is particularly advantageous in the following respect. When the convex body of the pressing means heated to the predetermined temperature is brought into contact with the tape, the tape is heated to increase the elongation while supported under tension by the tape support means. Therefore, when the pressing means is subsequently pressed against the second surface of the wafer to separate the chips individually, the chips so separated are caused to adhere to the tape. The subsequent separation of the pressing means away from the wafer is accompanied by a corresponding movement of the wafer ring so that a tape held taut on the wafer ring can be automatically fitted to the second surface of the wafer thereby to retain the separated chips. In this way, the application of the tape, the separation of the wafer and the expansion of the tape are all performed automatically in the apparatus according to the present invention.

In any event, in the apparatus of the present invention, the pressing means may be positioned either above or beneath the wafer supported by the mat. Where the pressing means is positioned beneath the wafer, the pressing means may be held still while the wafer can be driven by the drive means in a direction close toward or away from the pressing means. Alternatively, where the pressing means is positioned beneath the wafer, the wafer may be held still while the pressing means can be driven by the drive means in a direction close towards and away from the wafer.

### BRIEF DESCRIPTION OF THE DRAWINGS

This and other objects and features of the present invention will become clear from the following description taken in conjunction with preferred embodiments thereof with reference to the accompanying drawings, in which:
Fig. 1 is a schematic side view of an apparatus for fabricating a semiconductor device according to a first preferred embodiment of the present invention;
Figs. 2(a) and 2(b) are fragmentary sectional views showing how a wafer deforms when pressed by a pressing means;
Figs. 3 and 4 are schematic side views of the apparatus according to second and third embodiments of the present invention; and
Fig. 5 is a schematic side view of the prior art apparatus, reference to which has been made.

### DETAILED DESCRIPTION OF THE EMBODIMENTS

Before the description of the present invention proceeds, it is to be noted that like parts are designated by like reference numerals.

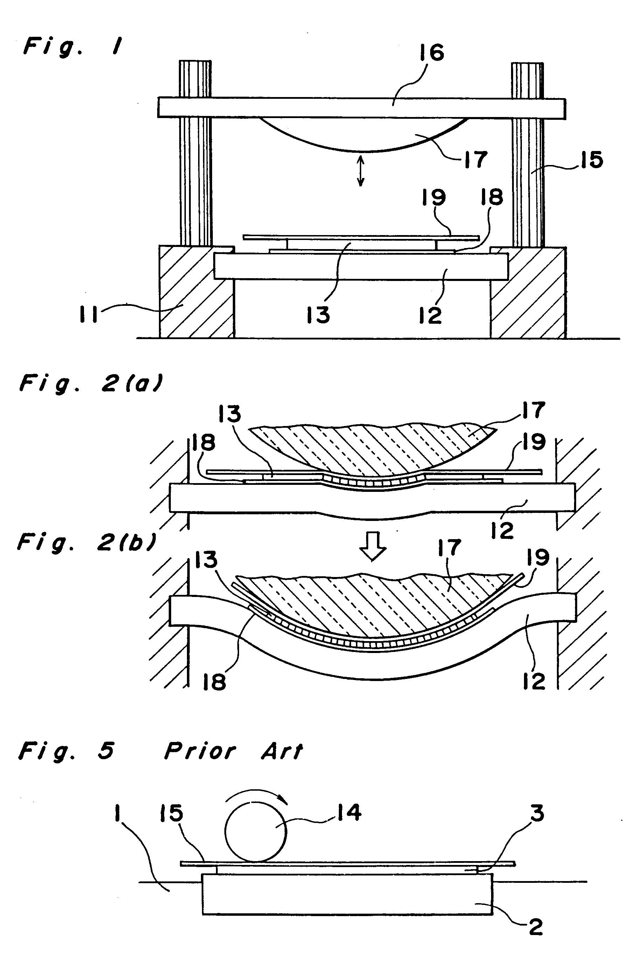

Referring first to Fig. 1, an apparatus for making a semiconductor device according. to the embodiment shown therein comprises a generally ring-shaped base 11 having a generally circular rubber mat 12 mounted thereon so as to close the opening of the ring-shaped base 11. At least three, preferably four, upright posts 15 are rigidly mounted on the base 11 so as to extend upwardly therefrom and spaced an equal distance in a direction circumferentially of the base 11. The upright posts 15 carries a generally circular pressing plate 16 mounted thereon so as to lie horizontal, i.e., in a plane perpendicular to any one of the upright posts 15, and so as to move in a direction close towards and away from the rubber mat 12 along the upright posts 15. The pressing plate 16 has one surface formed with a generally hemispherical body 17 protruding downwardly towards the rubber mat 12. A drive mechanism used to move the pressing plate 16 in a direction close towards and away from the rubber mat 12 along the upright posts 15 is not illustrated, but may be of any known construction.

When the apparatus of the construction described above with reference to Fig. 1 is to be operated, a wafer 13 having first and second surfaces opposite to each other with chips formed on the first surface thereof is placed on the rubber mat 12 through a surface protective tape 18 laid between the rubber mat 12 and the wafer 13. During this placement, care must be taken that the wafer 13 should be placed on the rubber mat 12 with the chips on the first surface thereof held in contact with the protective tape 18 and with the second surface confronting upwards. The second surface of the wafer 13 has a tape 19 applied thereto and, hence, when the wafer 13 is placed on the rubber mat 12 in the manner as hereinabove described, the tape 19 on the second surface of the wafer 12 faces upwards, in a direction opposite to the rubber mat 12.

After the placement of the wafer 13, the drive mechanism is operated to move the pressing plate 16 downwards in a direction close towards the wafer 13 on the rubber mat 12 along the upright posts 15. Consequent upon the downward movement of the pressing plate 16, the generally hemispherical body 17 on the pressing plate 16 is brought into contact with the wafer 13 through the tape 19 substantially as shown in Fig. 2(a). After the generally hemispherical body 17 has been brought into contact with the wafer 13 while the pressing plate 16 is being further moved downwards, the wafer 13 together with the rubber mat 12 is downwardly deformed, i.e., concaved, by the application of a pressing force thereto from the hemispherical body 17, representing a rounded recess which follows the curvature of the hemispherical body 17 as shown in Fig. 2(b). As the wafer 13 is so deformed together with the rubber mat 12, cracking is initiated in the wafer 13 from a central area thereof and extends towards the periphery of the wafer 13, however, the pressing force applied from the hemispherical body 17 to the wafer does no longer act on the wafer once the cracking takes place to separate the chips individually.

Accordingly, even though the wafer has a greater thickness at a peripheral area thereof than that at the central area thereof because of the presence of a film such as SiN film, the chips formed on the wafer 13 receive a uniform pressing force transmitted from the hemispherical body 17. The application of the pressing force uniformly over the chips on the wafer 13 results not only in the minimization of any possible damage to the chips, but also in the separation of the chips in both of x-axis and y-axis directions perpendicular to each other.

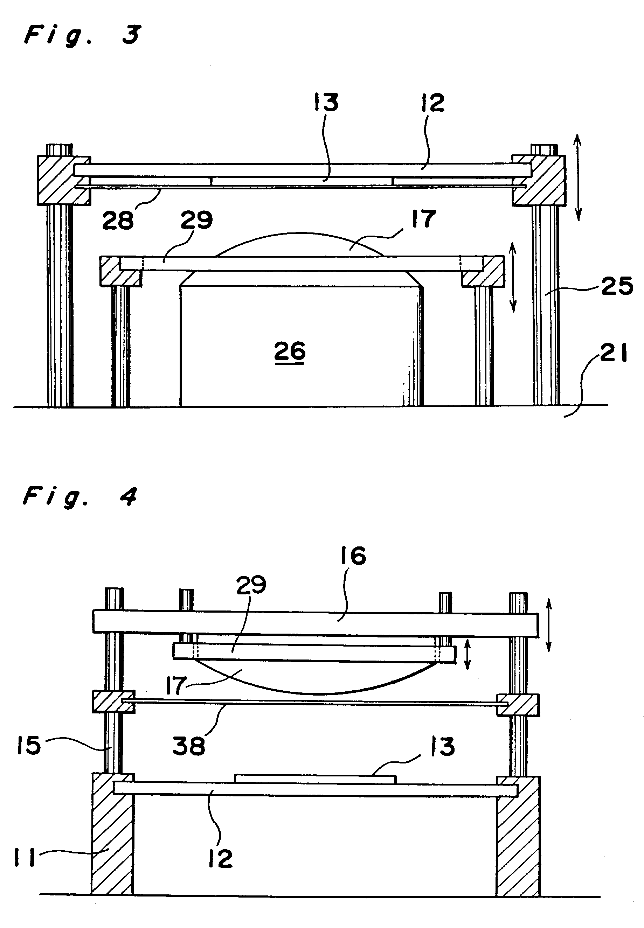

In a second preferred embodiment shown in Fig. 3, the apparatus comprises a base 21 having at least three, preferably four, upright posts 25 secured thereto so as to extend upwards, and a generally circular rubber mat 12 mounted thereon through a generally ring-shaped member for movement in a direction close towards and away from the base 21 along the upright posts 25, said rubber mat 12 lying horizontal, i.e., in a plane perpendicular to any one of the upright posts 25. The ring-shaped member supporting the rubber mat 12 also supports a tape 28 on which the wafer 13 is placed, said tape 28 being positioned immediately beneath the rubber mat 12.

The apparatus also comprises a pressing block 26 rigidly mounted on the base 21 and having a generally hemispherical body 17 integrally formed therewith and protruding upwardly so as to confront the wafer 13, and a wafer ring 29 surrounding the hemispherical body 17 and supported on a plurality of support posts for movement up and down in a direction parallel to any one of the support posts. The hemispherical body 17 is of a type having a heater embedded therein for heating the hemispherical body 17 to a predetermined temperature, for example, about 60°C.

When the apparatus according to the second preferred embodiment is to be operated, the wafer 13 is placed on the tape 28 with the chips on the first surface thereof confronting the rubber mat 12. Thereafter, the drive mechanism (not shown) is operated to move the wafer 13 together with the rubber mat 12 and the tape 28 downwardly in a direction close towards the hemispherical body 17, thereby bringing the wafer 13 into contact with the hemispherical body 17 while the wafer 13 is permitted to deform together with the rubber mat 13 to represent a rounded recess which follows the curvature of the hemispherical body 17. It is to be noted that shortly before the wafer 13 is deformed in contact with the hemispherical body 17, the latter is brought into contact with the tape 28 and, therefore, the tape 28 is heated in contact with the hemispherical body 17. When the tape 28 is so heated, the ductility of the tape 28 is enhanced.

As the wafer 13 is so deformed together with the rubber mat 12, cracking is initiated in the wafer 13 from a central area thereof and extends towards the periphery of the wafer 13, however, the pressing force applied from the hemispherical body 17 to the wafer does no longer act on the wafer once the cracking takes place to separate the chips individually.

After the cracking occurring in the wafer 13, the rubber mat 12 is, together with the wafer 13, further moved a predetermined distance downwards to allow the tape 28 to elongate or expand while separating the chips individually. Thereafter, the wafer ring 29 is upwardly shifted by a suitable drive mechanism (not shown) along the support posts to apply a tape 28, which has previously been expanded thereover, to the wafer 13 from below.

Thus, from the foregoing description, it is clear that, with the apparatus according to the second preferred embodiment of the present invention, not only can the chips on the wafer be separated individually, but the application of the tape to the wafer can also be accomplished, thereby minimizing the number of steps required to manufacture the semiconductor device.

Referring now to Fig. 4, the apparatus shown therein is generally similar to that shown in and described with reference to Fig. 1. However, the apparatus shown in Fig. 4 may be considered a version of the apparatus of Fig. 1 in which a wafer ring 29 corresponding in function to the wafer ring 29 shown in and described with reference to Fig. 3 is provided for automatically applying a tape to the wafer 13. For this purpose, the apparatus shown in Fig. 4 is provided not only with the wafer ring 29, but also with a support ring slidably mounted on the upright posts 15 for movement up and down along the upright posts 15, said support ring having a tape 38 stretched thereon so as to lie immediately below the hemispherical body 17. The wafer ring 29 used in the apparatus of Fig. 4 has a plurality of slide rods extending upwardly from the wafer ring 29 and extending slidably through the presser plate for movement up and down independently of the movement of the presser plate 16, said slide rods being in turn drivingly coupled with a ring drive mechanism (not shown).

More specifically, the apparatus shown in Fig. 4 is so designed as to operate in the following manner.

The wafer 13 having the chips on the first surface thereof is placed on the rubber mat 12 with the chips on held in contact with the rubber mat 12. After the placement of the wafer 13, the drive mechanism is operated to move the pressing plate 16 downwards in a direction close towards the wafer 13 on the rubber mat 12 along the upright posts 15.

During the downward movement of the pressing plate 16, the hemispherical body 17 then heated to about 60° is brought into contact with the tape 38 to enhance the ductility of the tape 38. The pressing plate 16 is then further moved downwards until the hemispherical body 17 is brought into contact with the wafer 13 on the rubber mat 12. After the hemispherical body 17 has been brought into contact with the wafer 13 while the pressing plate 16 is being further moved downwards, the wafer 13 together with the rubber mat 12 is downwardly deformed, i.e., concaved, by the application of a pressing force thereto from the hemispherical body 17, representing a rounded recess which follows the curvature of the hemispherical body 17. As the wafer 13 is so deformed together with the rubber mat 12, cracking is initiated in the wafer 13 from a central area thereof and extends towards the periphery of the wafer 13, however, the pressing force applied from the hemispherical body 17 to the wafer does no longer act on the wafer once the cracking takes place to separate the chips individually.

After the cracking occurring in the wafer 13, the wafer ring 29 is lowered to retain the tape 38 pressed against the rubber mat 12. When the pressing plate 16 in the lowered position is then elevated to leave away from the rubber mat 12, the tape 38 then expanded by the wafer ring 29 is applied to the wafer 12. Thereafter, the wafer ring 29 is upwardly shifted in readiness for the removal of the separated chips then retained in position by the applied tape 38.

## Claims

1. An apparatus for fabricating a semiconductor device which comprises:
a flexible mat (12);
means (11) for supporting the flexible mat (12) in a substantially horizontal position;
a pressing means (16) having a generally hemispherical convex body (17) and supported for movement up and down; and
a drive means for driving either said pressing means (16) relative to said flexible mat (12), or said mat relative to said pressing means (16) so as to move up and down, such that when a wafer (13) having first and second surfaces opposite to each other with chips formed on the first surface thereof, placed on the mat (12) with the chips confronting the flexible mat (12), is pressed by said hemispherical body (17) of the pressing means (16) by contact of the hemispherical body against the centre of the second surface of the wafer (13) the chips on the wafer (13) are separated individually, said separation being initiated from the centre of the wafer.

2. Apparatus as claimed in claim 1, wherein said flexible mat (12) is circular in shape.

3. Apparatus as claimed in claim 1 or claim 2, wherein said flexible mat (12) is made of rubber.

4. Apparatus as claimed in any one of the preceding claims, wherein said pressing means (16) comprises at least three upright rods (15) and a pressing plate (16) having the hemispherical body (17).

5. Apparatus as claimed in any one of the preceding claims which comprises:
means for supporting a tape (28) horizontally under tension beneath the flexible mat (12) and above the pressing means (26);
a heating means for heating the hemispherical body (17) to a predetermined temperature; and
a drive means for driving said mat supporting means and said tape supporting means relative to the pressing means (26) such that when a wafer (13) having first and second surfaces opposite to each other with chips formed on the first surface thereof, placed on the tape (28) with the chips confronting the tape (28), is pressed by said hemispherical body (17) through said tape against the second surface of the wafer the chips on the wafer (13) are separated individually and said tape (28) is, at the same time, expanded to completely separate the chips.

6. Apparatus as claimed in any one of claim 1 to 4 for fabricating a semiconductor device which comprises:
means for supporting a tape (38) horizontally under tension above the flexible mat (12) and below the pressing means (16);
a heating means for heating the hemispherical convex body (17) to a predetermined temperature; and
a drive means for driving said mat supporting means and said tape supporting means relative to the pressing means (16), such that when a wafer (13) having first and second surfaces opposite to each other with chips formed on the first surface thereof, placed on the mat (12) with the chips confronting the flexible mat (12), is pressed by said hemispherical convex body of the pressing means through said tape the chips are separated on the wafer individually and said tape (38) is, at the same time, expanded to completely separate the chips.

7. Apparatus as claimed in claim 5 or 6, wherein the predetermined temperature is about 60°C.

8. Apparatus as claimed in any one of the preceding claims, further comprising a wafer ring (29) supported for movement up and down and a ring drive means for driving the wafer ring (29).

## Patentansprüche

1. Vorrichtung zum Herstellen eines Halbleiterbauteils mit:
einer flexiblen Matrize (12);
einer Einrichtung (11), um die flexible Matrize (12) in einer im wesentlichen horizontalen Lage zu haltern;
einer Preßeinrichtung (16), die im allgemeinen einen halbkugeligen konvexen Körper (17) aufweist und für eine Aufwärts- und Abwärtsbewegung gehaltert ist; und
einer Antriebseinrichtung, um entweder die Preßeinrichtung (16) relativ zu der flexiblen Matrize (12), oder die flexible Matrize (12) relativ zu der Preßeinrichtung (16) so anzutreiben, um sie in der Weise aufwärts und abwärts zu bewegen, so daß dann, wenn ein Wafer (13) mit ersten und zweiten einander gegenüberliegenden Oberflächen und auf seiner ersten Oberfläche ausgebildeten Chips, der mit den Chips der flexiblen Gummimatrize (12) zugewandt auf der Matrize (12) angeordnet ist, durch den halbkugeligen Körper (17) der Preßeinrichtung (16) über den Kontakt des halbkugeligen Körpers gegen den Mittelpunkt der zweiten Oberfläche des Wafers (13) gepreßt wird, die Chips auf dem Wafer (13) in Einzelstücke getrennt werden, wobei die Trennung vom Mittelpunkt des Wafers aus eingeleitet wird.

2. Vorrichtung nach Anspruch 1, wobei die flexible Matrize (12) eine runde Form aufweist.

3. Vorrichtung nach Anspruch 1 oder 2, wobei die flexible Matrize (12) aus Gummi besteht.

4. Vorrichtung nach einem der vorstehenden Ansprüche, wobei die Preßeinrichtung (16) mindestens drei aufrecht stehende Pfosten (15) und eine Preßplatte (16) mit dem halbkugeligen Körper (17) aufweist.

5. Vorrichtung nach einem der vorstehenden Ansprüche mit:
einer Einrichtung, um ein Band (28) in horizontaler Richtung unter Spannung unterhalb der flexiblen Matrize (12) und über der Preßeinrichtung (26) zu haltern;
einer Heizeinrichtung zum Aufheizen des halbkugeligen Körpers (17) auf eine vorgegebene Temperatur; und
einer Antriebseinrichtung, um die Matrizenhalteeinrichtung und die Bandhalteeinrichtung relativ zu der Preßeinrichtung (26) in der Art anzutreiben, so daß dann, wenn ein Wafer (13) mit ersten und zweiten einander gegenüberliegenden Oberflächen und auf seiner ersten Oberfläche ausgebildeten Chips, der mit den Chips dem Band (28) zugewandt auf dem Band (28) angeordnet ist, durch den halbkugeligen Körper (17) über das Band gegen die zweite Oberfläche gedrückt wird, die Chips auf dem Wafer (13) in Einzelstücke getrennt werden und das Band (28) zum gleichen Zeitpunkt gedehnt wird, um die Chips vollständig zu trennen.

6. Vorrichtung nach einem der Ansprüche 1 bis 4 zum Herstellen eines Halbleiterbauteils mit:
einer Einrichtung, um ein Band (38) in horizontaler Richtung unter Spannung über der flexiblen Matrize (12) und unterhalb der Preßeinrichtung (16) zu haltern;
einer Heizeinrichtung zum Aufheizen des halbkugeligen konvexen Körpers (17) auf eine vorgegebene Temperatur; und
einer Antriebseinrichtung, um die Matrizenhalteeinrichtung und die Bandhalteeinrichtung relativ zu der Preßeinrichtung (16) in der Art anzutreiben, so daß dann, wenn ein Wafer (13) mit ersten und zweiten einander gegenüberliegenden Oberflächen und auf seiner ersten Oberfläche ausgebildeten Chips, der mit den Chips der flexiblen Matrize (12) zugewandt auf der Matrize (12) angeordnet ist, durch den halbkugeligen konvexen Körper der Preßeinrichtung über das Band gepreßt wird, die Chips auf dem Wafer in Einzelstücke getrennt werden und das Band (38) zum gleichen Zeitpunkt gedehnt wird, um die Chips vollständig zu trennen.

7. Vorrichtung nach Anspruch 5 oder 6, wobei die vorgegebene Temperatur etwa 60°C ist.

8. Vorrichtung nach einem der vorstehenden Ansprüche, welche ferner einen für eine Aufwärts- und Abwärtsbewegung gehalterten Waferring (29) und eine Ringantriebseinrichtung für den Antrieb des Waferrings (29) aufweist.

## Revendications

1. Appareil pour la fabrication d'un dispositif à semi-conducteurs, comprenant :
un tapis souple (12) ;
un moyen (11) pour supporter le tapis souple (12) dans une position sensiblement horizontale ;
un moyen de pression (16) comportant un corps convexe globalement hémisphérique (17) et supporté pour se déplacer vers le haut et vers le bas ; et,
un moyen d'entraînement pour entraîner soit ledit moyen de pression (16) par rapport audit tapis souple (12), soit ledit tapis par rapport audit moyen de pression (16) en un déplacement vers le haut et vers le bas, de manière telle que, lorsqu'une plaquette (13) comportant des première et seconde faces opposées l'une à l'autre avec des puces formées sur sa première face, placée sur la tapis (12) les puces étant contre le tapis souple (12) est pressée par ledit corps hémisphérique (17) du moyen de pression (16) par contact du corps hémisphérique contre le centre de la seconde face de la plaquette (13), les puces sur la plaquette sont séparées individuellement, ladite séparation commençant à partir du centre de la plaquette.

2. Appareil selon la revendication 1, dans lequel ledit tapis souple (12) est de forme circulaire.

3. Appareil selon la revendication 1 ou la revendication 2, dans lequel ledit tapis souple (12) est fait de caoutchouc.

4. Appareil selon l'une quelconque des revendications précédentes, dans lequel ledit moyen de pression (16) comprend au moins trois tiges dressées verticalement (15) et une plaque de pression (16) portant le corps hémisphérique (17).

5. Appareil selon l'une quelconque des revendications précédentes, comprenant :
un moyen pour supporter une bande (28) horizontalement sous tension au-dessous du tapis souple (12) et au-dessus du moyen de pression (26) ;
un moyen chauffant pour chauffer le corps hémisphérique (17) à une température prédéterminée ; et,
un moyen d'entraînement pour entraîner ledit moyen supportant le tapis et ledit moyen supportant la bande par rapport audit moyen de pression (26), de manière telle que, lorsqu'une plaquette (13) comportant des première et seconde faces opposées l'une à l'autre avec des puces formées sur sa première face, placée sur la bande (28) les puces étant contre la bande (28) est pressée par ledit corps hémisphérique (17), par l'intermédiaire de ladite bande, contre la seconde face de la plaquette, les puces sur la plaquette (13) sont séparées individuellement et ladite bande (28) est, en même temps, expansée pour séparer complètement les puces.

6. Appareil selon l'une quelconque des revendications 1 à 4, pour la fabrication d'un dispositif à semi-conducteurs, comprenant :
un moyen pour supporter une bande (38) horizontalement sous tension au-dessus du tapis souple (12) et au-dessous du moyen de pression (16) ;
un moyen chauffant pour chauffer le corps convexe hémisphérique (17) à une température prédéterminée ; et,
un moyen d'entraînement pour entraîner ledit moyen supportant le tapis et ledit moyen supportant la bande par rapport audit moyen de pression (16), de manière telle que, lorsqu'une plaquette (13) comportant des première et seconde faces opposées l'une à l'autre avec des puces formées sur sa première face placée sur le tapis (12) les puces étant contre le tapis souple (12) est pressée par ledit corps convexe hémisphérique du moyen de pression, par l'intermédiaire de ladite bande, les puces sur la plaquette sont séparées individuellement et ladite bande (38) est, en même temps, expansée pour séparer complètement les puces.

7. Appareil selon la revendication 5 ou 6, dans lequel la température prédéterminée est d'environ 60° C.

8. Appareil selon l'une quelconque des revendications précédentes, comprenant en outre une bague de plaquette (29) supportée pour un déplacement vers le haut et vers le bas et un moyen d'entraînement de bague pour entraîner la bague de plaquette (29).
